# FASCICULE DE BREVET EUROPEEN

(11) **EP 0 613 596 B1**
(45) Date de publication et mention de la délivrance du brevet: **18.12.1996**
(21) Numéro de dépôt: 93913142.1
(22) Date de dépôt: 16.06.1993
(51) Int. Cl.: H03H 7/09, H03H 1/00

(54) **FILTRE RADIOELECTRIQUE DE FORTE ET MOYENNE PUISSANCE**
RADIOELEKTRISCHES FILTER FÜR HOHE UND MITTLERE LEISTUNG
HIGH AND MEDIUM POWER RADIOELECTRIC FILTER

(30) Priorité: 23.06.1992 FR 9207624
(43) Date de publication de la demande: 07.09.1994
(73) Titulaire: THOMSON-CSF, 75008 Paris (FR)
(72) Inventeur: HERMELIN, Jean, F-92402 Courbevoie Cédex (FR); RENVOISE, Yves, F-92402 Courbevoie Cédex (FR)
(74) Mandataire: Lincot, Georges
(86) Numéro de dépôt international: FR9300587
(87) Numéro de publication internationale: WO9400913

(56) Documents cités:
- EP-A- 0 481 607
- DE-A- 3 730 303
- FR-A- 2 544 543
- US-A- 4 502 029

## Description

La présente invention concerne un filtre radioélectrique de forte et moyenne puissance.

Dans les émetteurs-récepteurs classiques fonctionnant notamment dans la gamme VHF et dans des conditions difficiles de proximité, différents niveaux de filtrage sont nécessaires pour assurer une réjection efficace à l'émission des raies et du bruit émis et éliminer à la réception les signaux brouilleurs et les signaux parasites.

Il est connu de réaliser de tels filtres au moyen d'inductances couplées de la manière décrite par exemple dans la demande de brevet français n° 2 544 543 déposée au nom de la Demanderesse.

Suivant le mode de réalisation qui y est décrit et qui concerne plus particulièrement la réalisation d'un transformateur HF de puissance formé par deux inductances couplées entre elles par mutuelle induction, les inductances sont découpées dans une feuille de cuivre par un procédé photographique et chimique pour être ensuite collées sur une plaque de céramique. Des douilles permettent le branchement des connexions des inductances avec des dispositifs extérieurs. La plaque céramique est enfermée dans un boîtier métallique comportant deux rainures où elle est maintenue en contact avec le métal du boîtier par deux ressorts en accordéon, ceci afin de permettre d'assurer un blindage électromagnétique des inductances et la dissipation thermique nécessaire pour évacuer les calories produites par la puissance électrique dissipée par effet Joule dans les inductances.

L'inconvénient majeur de ce mode de réalisation est qu'il nécessite pour réaliser des filtres d'être complété par un câblage extérieur au boîtier pour permettre la réalisation de circuits oscillants par branchement de condensateurs en parallèle sur les inductances.

Pour des filtres à forte puissance utilisés en évasion de fréquence notamment, cela pose un problème d'optimisation des retours de masse des courants forts circulant dans les circuits oscillants, des problèmes de symétrie entre pôles de circuits oscillants, de répartition de poids de condensateurs, de refroidissement des diodes "PIN" de commutation des condensateurs formant avec les inductances les circuits oscillants du filtre, et de blindage des connexions ainsi réalisées ainsi que des problèmes d'encombrement préjudiciables à l'incorporation de ces circuits dans des postes radio tactiques portables ou portatifs.

Le but de l'invention est de pallier les inconvénients précités.

A cet effet, l'invention a pour objet un filtre radioélectrique de forte et moyenne puissance comportant au moins une inductance fixée à une plaque de circuit imprimé à l'intérieur d'un boîtier métallique caractérisé en ce qu'il comprend des douilles fixées par une de leurs extrémités à la plaque de circuit imprimé aux points de liaison de chaque inductance avec le circuit imprimé de la plaque et reliées par leurs autres extrémités à un condensateur et une diode "PIN" montés en série entre cette autre extrémité et une paroi du boîtier sur laquelle est fixé la diode "PIN".

L'invention a pour principal avantage qu'elle permet d'assurer une bonne reproductibilité du filtre lorsque celui-ci est fabriqué en série avec des coefficients de surtension élevés même en présence de dissipations thermiques des inductances et des diodes "PIN" importantes.

D'autres caractéristiques et avantages de l'invention apparaîtront ci-après à l'aide de la description qui suit faite en regard des dessins annexés qui représentent :
- la figure 1 un schéma électrique de principe d'un filtre mis en oeuvre par l'invention ;
- la figure 2 un mode de réalisation à l'intérieur d'un boîtier d'un filtre à forte puissance selon l'invention ;
- la figure 3 une vue en coupe du boîtier de la figure 2 figurant l'assemblage des condensateurs d'accord et des diodes "PIN" de commande des circuits résonnants du filtre ;
- la figure 4 un mode de réalisation d'une inductance pour filtre à moyenne puissance.

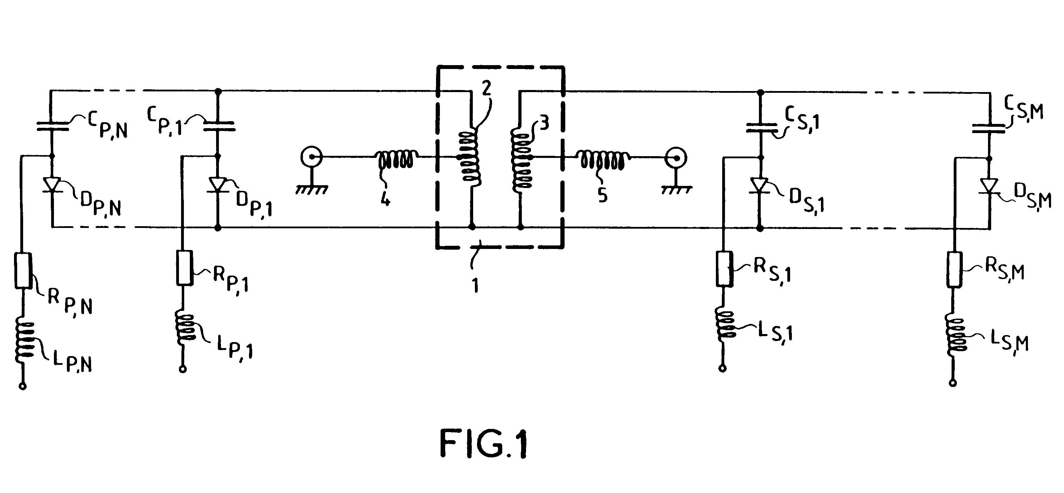

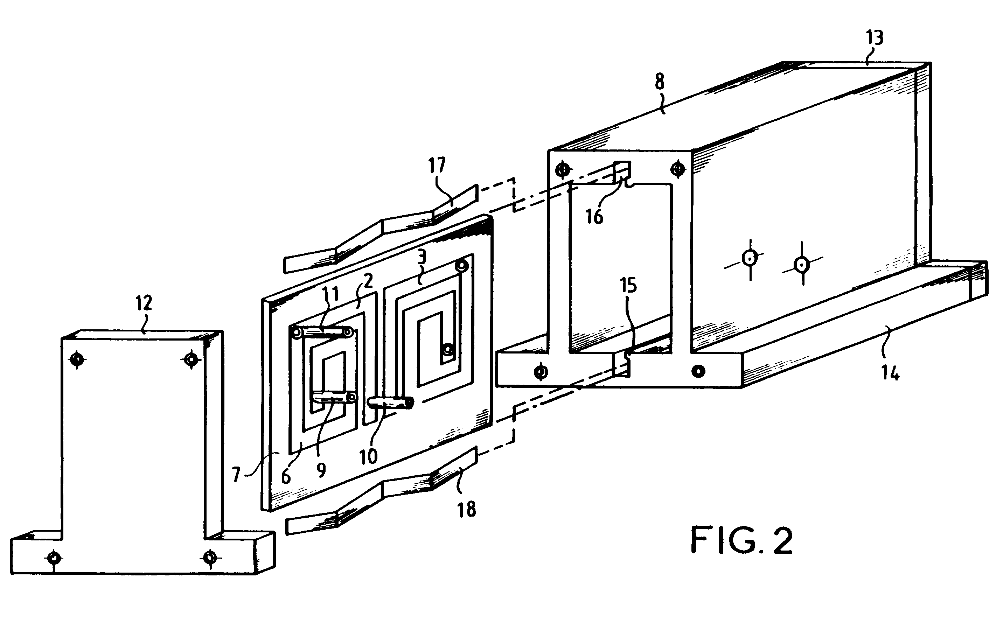

Le filtre qui est représenté suivant le schéma de principe de la figure 1, comporte un circuit couplé à mutuelles inductions 1 formé d'une inductance primaire 2 et d'une inductance secondaire 3 reliées respectivement à un premier et à un deuxième ensemble de condensateurs C_{p,n} et C_{s,m} connectables à volonté aux bornes d'extrémités des inductances 2 et 3 par l'intermédiaire de diodes "PIN" D_{p,n} et D_{s,m} où n et m sont des entiers compris entre 1 et N et 1 et M respectivement. Le point commun de liaison d'une diode "PIN" D_{p,n} ou D_{s,m} avec l'extrémité correspondante d'un condensateur C_{p,n} ou C_{s,m} est relié par l'intermédiaire d'une résistance R_{p,n} ou R_{s,n} branchée en série avec une inductance de choc L_{p,n}, respectivement L_{s,m}, à un circuit de commande non représenté. Suivant cette configuration et conformément au sens de branchement des diodes représentées, lorsqu'une tension positive est appliquée sur l'extrémité libre d'une inductance L_{p,n} respectivement L_{s,m} chaque diode "PIN" correspondante est placée dans son état de conduction en réalisant ainsi le branchement du condensateur C_{p,n} respectivement C_{s,m} correspondant aux bornes d'extrémité des inductances 2, respectivement 3, du circuit couplé 1 pour former chaque fois un circuit oscillant. Inversement lorsqu'une tension négative est appliquée sur l'extrémité libre d'une inductance L_{p,n} respectivement L_{s,m} la diode "PIN" correspondante est bloquée et le condensateur C_{p,n} ou C_{s,m} correspondant est déconnecté de l'inductance L_{p,n} respectivement L_{s,m}. Chacune des inductances 2 et 3 comporte une prise reliée respectivement à une inductance 4 et 5, formant respectivement l'entrée et la sortie du filtre. Dans l'exemple de réalisation du filtre de la figure 2, le circuit couplé 1 est découpé, de la façon déjà décrite dans la demande de brevet précitée, dans une plaque de cuivre 6 d'environ 500 microns d'épaisseur et recouverte des deux côtés d'une couche d'argent électrolithique d'environ 5 microns d'épaisseur. La forte épaisseur du métal procure une bonne conductibilité thermique et le revêtement d'argent procure une bonne conductibilité électrique pelliculaire. Les inductances 2 et 3 sont collées sur une plaque 7 en céramique à 96% d'alumine par exemple et d'épaisseur d'environ 1,27mm. Afin de transmettre la chaleur dissipée par les inductances et ne pas provoquer de pertes supplémentaires, la céramique utilisée a une conductibilité thermique supérieure à 0,05 calorie par cm/cm².s.°C mais un angle de perte à 100 MHz inférieurs à 5.10⁻⁴. Cependant d'autres réalisations sont encore possibles en utilisant par exemple une plaque en verre epoxy.

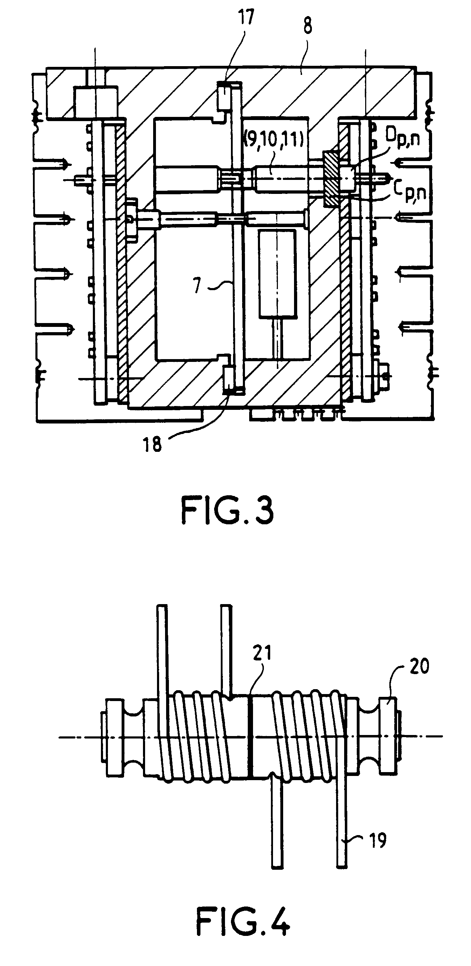

De manière similaire à ce qui est décrit dans la demande de brevet précitée la plaque 7 est enfermée dans un boîtier métallique 8. Des douilles 9, 10 et 11 ont leurs extrémités fixées dans la plaque de céramique 7 aux points d'extrémité et au milieu des inductances 2 et 3 pour relier les inductances aux extrémités correspondantes des condensateurs C_{p,n}, respectivement C_{s,m}, et des diodes "PIN" D_{p,n} et D_{s,m} conformément au schéma de la figure 1 et permettre la connection par diodes des condensateurs d'accord. Cette connexion est réalisée de la manière représentée par la vue en coupe de la figure 3, par empilage à l'extrémité libre de chaque colonnette 9, 10 et 11 d'un condensateur C_{p,n} avec la diode "PIN" correspondante D_{p,n}, respectivement C_{s,n} et D_{s,m}. Dans cet empilage le corps de chaque diode "PIN" est mis en contact avec la paroi du boîtier 8 qui constitue pour le filtre à la fois un blindage radioélectrique et un dissipateur de chaleur. Ce boîtier est par exemple réalisé en aluminium recouvert d'un dépôt électrolithique de cuivre de 15 microns d'épaisseur et d'un dépôt d'argent de 7 microns d'épaisseur. Il comprend un profilé creux fermé à ses deux extrémités par deux flasques rapportées 12, 13. Le profilé creux a une section interne rectangulaire et une section externe comportant une semelle 14 longitudinale large permettant de fixer le boîtier sur une surface plane et de transmettre à cette surface plane la chaleur dissipée par le filtre. Le profilé comporte deux rainures 15, 1G creusées à l'intérieur parallèlement à son grand axe. La périphérie de la seconde face de la plaque 7 est en contact avec une première paroi des rainures sous la pression respectivement de deux ressorts 17, 18 en accordéon qui sont insérés respectivement entre la première face de la plaque 7 et la seconde paroi de chacune des rainures 15, 16.

L'invention n'est pas limitée au mode de réalisation qui vient d'être décrit notamment en ce qui concerne la réalisation des inductances 2 et 3 formant le circuit couplé 1 du filtre. Bien évidemment l'invention s'applique aussi par exemple à des réalisations où les inductances sont obtenues non par gravures ou découpes d'une plaque de cuivre mais au moyen d'un fil de cuivre bobiné autour de la plaque de circuit imprimé ou encore autour d'un mandrin. Dans ce dernier cas, pour obtenir une parfaite reproductibilité des inductances celles-ci peuvent être constituées de la manière représentée à la figure 4 par un bobinage en fil de cuivre argenté 19 de diamètre d'environ 2mm par exemple, effectué sur un mandrin rainuré 20. Ce mandrin peut être usiné de préférence dans un matériau très stable possédant d'excellentes caractéristiques en hautes fréquences telles que le matériau connu sous la désignation Noryl GFN1 avec une précision de l'ordre de 5/100 de mm. Un écran électrostatique constitué par exemple par une spire plate ouverte 21 reliée à la masse peut être positionné au centre du bobinage pour assurer une réduction des capacités parasites de couplage entre les inductances.

De façon à pouvoir réaliser une inductance d'accord de valeur la plus élevée possible et afin de profiter d'un coefficient de surtension à vide maximum, les diodes "PIN" utilisées doivent avoir une très faible capacité inverse de l'ordre de 0,8 PF et une résistance parallèle élevée en régime de contre polarisation et d'autre part une faible résistance série en régime de conduction. Pour réduire les pertes séries, les points de retour de masse du bobinage et les diodes doivent être soudés de préférence directement sur le blindage formé par le boîtier 8. Il pourra en être de même pour les embases coaxiales qui assurent les entrées-sorties du filtre.

L'invention n'est pas non plus limitée à un nombre déterminé de circuits oscillants pour composer le filtre et il est bien évident qu'elle s'applique également au cas particulier où le filtre comporte qu'une seule inductance pour former un seul circuit oscillant.

Elle n'est pas non plus limitée à la nature du matériau composant la plaque 7, pourvu que celui-ci possède un faible angle de perte.

## Revendications

1. Filtre radioélectrique de forte et moyenne puissance comportant au moins une inductance (2, 3) fixée à une plaque de circuit imprimé (7) à l'intérieur d'un boîtier métallique (8) caractérisé en ce qu'il comprend des douilles (9, 10, 11) fixées par une de leurs extrémités à la plaque de circuit imprimé aux points de liaison de chaque inductance (2, 3) avec le circuit imprimé de la plaque et reliées par leurs autres extrémités à un condensateur (C_{p,n}, C_{s,m}) et une diode "PIN" (D_{p,n}, D_{s,m}) montés en série à chaque autre extrémité entre une douille et une paroi du boîtier (8) sur laquelle est fixée la diode "PIN" (D_{p,n}, D_{s,m}).

2. Filtre selon la revendication 1 caractérisé en ce que chaque inductance (2, 3) est découpée dans une feuille métallique de faible résistance thermique disposée à plat sur la plaque de circuit imprimé.

3. Filtre selon la revendication 1 caractérisé en ce que chaque inductance (2, 3) est formée par un circuit imprimé gravé sur la plaque de circuit imprimé.

4. Filtre selon la revendication 1 caractérisé en ce que l'inductance (2, 3) est formée par un fil bobiné sur un mandrin.

5. Filtre selon l'une quelconque des revendications 1 à 4 caractérisé en ce que la plaque de circuit imprimé (7) est en céramique.

6. Filtre selon l'une quelconque des revendications 1 à 5 caractérisé en ce que la plaque de circuit imprimé est en verre epoxy.

7. Filtre selon l'une quelconque des revendications 1 à 6 caractérisé en ce que la plaque (7) est engagée dans deux rainures à l'intérieur du boîtier (8) où elle est maintenue en contact par deux ressorts (17, 18) pour transmettre la chaleur dissipée par les inductances (2, 3).

## Patentansprüche

1. Radioelektrisches Filter für hohe und mittlere Leistung mit wenigstens einer Induktivität (2, 3), die an einer Leiterplatte (7) im Inneren eines Metallgehäuses (8) befestigt ist, dadurch gekennzeichnet, daß es Buchsen (9, 10, 11) enthält, die mit einem ihrer Enden an der Leiterplatte an Verbindungspunkten jeder Induktivität (2, 3) mit der Leiterplatte befestigt ist und mit ihren anderen Enden mit einem Kondensator (C_{p,n}, C_{s,m}) und einer "PIN"-Diode (D_{p,n,} D_{s,m}) verbunden sind, die in serie mit jedem anderen Ende zwischen einer Buchse und einer Wand des Gehäuses (8) angebracht sind, an der die "PIN"-Diode (D_{p,n}, D_{s,m}) befestigt ist.

2. Filter nach Anspruch 1, dadurch gekennzeichnet, daß jede Induktivität (2, 3) aus einer Metallfolie mit niedrigem thermischen Widerstand ausgeschnitten ist, die liegend auf der Leiterplatte angeordnet ist.

3. Filter nach Anspruch 1, dadurch gekennzeichnet, daß jede Induktivität (2, 3) durch eine auf der Leiterplatte geätzte gedruckte Schaltung gebildet ist.

4. Filter nach Anspruch 1, dadurch gekennzeichnet, daß die Induktivität (2, 3) durch einen auf einen Dorn gewickelten Draht gebildet ist.

5. Filter nach einem der Ansprüche 1 bis 4, dadurch gekennzeichnet, daß die Leiterplatte (7) aus Keramikmaterial besteht.

6. Filter nach einem der Ansprüche 1 bis 5, dadurch gekennzeichnet, daß die Leiterplatte aus glasfaserverstärktem Epoxydharz besteht.

7. Filter nach einem der Ansprüche 1 bis 6, dadurch gekennzeichnet, daß die Platte (7) in zwei Nuten im Inneren des Gehäuses (8) eingesetzt ist, in denen sie mit Hilfe von zwei Federn (17, 18) zum Übertragen der von der Induktivität (2, 3) umgesetzten Wärme gehalten wird.

## Claims

1. High- and medium-power radio frequency filter including at least one inductor (2, 3) fixed to a printed circuit board (7) within a metal casing (8) characterized in that it comprises bushes (9, 10, 11) fixed by one of their ends to the printed circuit board at the points where each inductor (2, 3) is linked with the printed circuit of the board, and linked by their other ends to a capacitor (C_{p,n}, C_{s,m}) and a "PIN" diode (D_{p,n}, D_{s,m}) which are mounted in series at each other end between a bush and one wall of the casing (8) on which the "PIN" diode (D_{p,n}, D_{s,m}) is fixed.

2. Filter according to Claim 1, characterized in that each inductor (2, 3) is cut out from a metal sheet of low thermal resistance arranged flat on a printed circuit board.

3. Filter according to Claim 1, characterized in that each inductor (2, 3) is formed by a printed circuit etched on the printed circuit board.

4. Filter according to Claim 1, characterized in that the inductor (2, 3) is formed by a wire wound on a former.

5. Filter according to any one of Claims 1 to 4, characterized in that the printed circuit board (7) is of ceramic.

6. Filter according to any one of Claims 1 to 5, characterized in that the printed circuit board is of epoxy glass.

7. Filter according to any one of Claims 1 to 6, characterized in that the board (7) is engaged in two grooves within the casing (8) where it is held in contact by two springs (17, 18) in order to transmit the heat dissipated by the inductors (2, 3).
